(19) **Europäisches Patentamt**
**European Patent Office**
**Office européen des brevets**

(11) **EP 2 626 287 A1**

(12) **EUROPEAN PATENT APPLICATION**
published in accordance with Art. 153(4) EPC

(43) Date of publication:
14.08.2013 Bulletin 2013/33

(51) Int Cl.:
**B63B 9/00** (2006.01) **G06F 17/50** (2006.01)

(21) Application number: **11830639.8**

(22) Date of filing: **03.10.2011**

(86) International application number:
**PCT/JP2011/072813**

(87) International publication number:
**WO 2012/046707 (12.04.2012 Gazette 2012/15)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.10.2010 JP 2010225695**

(71) Applicant: **Mitsubishi Heavy Industries, Ltd.
Tokyo 108-8215 (JP)**

(72) Inventors:
• **KAWAKITA Chiharu
Tokyo 108-8215 (JP)**

• **KITAMURA Toru
Tokyo 108-8215 (JP)**
• **ONAKA Shigeki
Tokyo 108-8215 (JP)**
• **USHIROGOCHI Yuichi
Tokyo 108-8215 (JP)**
• **ARAKI Shinichi
Shimonoseki-shi
Yamaguchi 750-8505 (JP)**

(74) Representative: **Henkel, Breuer & Partner
Patentanwälte
Maximiliansplatz 21
80333 München (DE)**

(54) **SHIP DESIGN ASSISTANCE SYSTEM**

(57)    A ship design assistance system is provided with: a storing unit for storing data pertaining to the overall arrangement model containing a hull structure model functioning as a 3D model for the hull structure, and an equipment model functioning as a 3D model for the equipment; and a model creation and modification unit for modifying the overall arrangement model on the basis of data of the final lines plan representing the hull form of a ship to be constructed. It is possible to concurrently design the overall arrangement and the hull form, thereby shortening the amount of time needed from starting the design to completing same.

Fig. 2

# Description

## Technical Field

The present invention relates to shipbuilding and more particularly relates to a design of a ship.

## Background Art

Conventionally, in a design of a ship, a building-up type design was carried out by considering a type of ship, a structure and furniture for each ship. In the ship shape design, a process is repeated in which the performance of the ship shape designed by a designer is evaluated and the design is again carried out by the designer on the basis of its evaluation result, to a final ship shape is determined. Therefore, a large amount of times were required. Thus, when the structure design and the furniture design are started after the determination of the final ship shape, a design lead time, namely, a necessary time from the start of the design to the completion becomes very long. When the structure design and the furniture design are started prior to the determination of the final ship shape, the lead time of the design is made short. However, since the structure design and the furniture design are again tried after the determination of the final ship shape, there is a fear of a lowering in a design quality.

Patent Literature 1 (JP 2004-9858A) discloses a ship design apparatus for simplifying the design of the ship that is superior in a hydrodynamic performance.

Also, in recent years, when a new product is developed, a digital mockup is used to consider its appearance, its inner structure and its operation. Patent Literature 2 (JP 2004-118266A) and Patent Literature 3 (JP 2006-221534A) disclose the techniques related to the digital mockup.

## Citation List

[Patent Literature 1] JP 2004-9858A
[Patent Literature 2] JP 2004-118266A
[Patent Literature 3] JP 2006-221534A

## Summary of the Invention

An object of the present invention is to provide a ship design supporting system and a ship building method, in which a time from start of design to completion can be reduced.

In the first view of the present invention, a ship design supporting system includes a storage section for storing general arrangement model data describing a general arrangement model which contains a hull structure model as a 3-dimensional model of a hull structure and an equipment apparatus model as a 3-dimensional model of an equipment apparatus; and a model producing and changing section for changing the general arrangement model based on a final line plan data which shows a shape of a ship to be built.

According to the above ship design supporting system, because the general arrangement design and the ship shape design can be carried forward in parallel, a time from start of design to completion can be reduced.

Preferably, the hull structure model contains an outer plate model as the 3D-dimensional model of outer plate and a strength member model as a 3D-dimensional model of a bulkhead, a big rib, a support pillar, a deck or a double bottom. The model producing and change section changes the outer plate model based on the final line plan data and changes the strength member model to follow the change of the outer plate model.

Preferably, the strength member model contains a first strength member model as a 3D-dimensional model of the bulkhead or the deck. The model producing and change section removes a part of the first strength member model which sticks out from the outer plate model after the change.

Preferably, the strength member model contains a second strength member model as a 3-dimensional model of a frame extending along the outer plate. The model producing and changing section changes the second strength member model such that the second strength member model extends along the outer plate model after the change.

Preferably, the above ship design supporting system further includes an input section which is operated by an operator. The model producing and changing section selects a first block model from a block model library as a candidate of a 3-dimensional model of a first block of the ship to be built based on an operation of the input section, and produces the general arrangement model such that the general arrangement model contains the first block model, based on initial general arrangement data which shows initial line plan data representing the ship shape and representing an arrangement of the block. The first block model contains a first block hull structure model as a 3-dimensional model of the hull structure; and a first block equipment apparatus model as a 3D-dimensional model of an equipment apparatus. The hull structure model contains the first block hull structure model, and the equipment apparatus model contains the first block equipment apparatus model.

Preferably, the above ship design supporting system further includes an input section which is operated by an operator. The model producing and changing section selects a first block model from a block model library as a candidate of a 3-dimensional model of a first block of the ship to be built, based on an operation of the input section, selects a second block equipment apparatus model as a 3-dimensional model of an equipment apparatus from an equipment apparatus model library based on an operation of the input section, produces a second block hull structure model as a 3-dimensional model of the hull structure based on an operation of the input section, produces a second block model which contains the second block hull structure model and the second block equipment apparatus model as a candidate of a 3D-dimensional model of a second block of the ship to be built, based on an operation of the input section, and produces the general arrangement model such that the general arrangement model contains the first block model and the second block model, based on initial line plan data showing the shape of the ship and initial general arrangement data showing the arrangement of blocks. The first block model contains a first block equipment apparatus model as a 3D-dimensional model of an equipment apparatus, the hull structure model contains the second block hull structure model, and the equipment apparatus model contains the first block equipment apparatus model and the second block equipment apparatus model.

Preferably, the above ship design supporting system further includes a model registering section for registering the second block model on the block model library.

Preferably, the above ship design supporting system further includes a template producing section for producing a template in which a producing process of the second block model is registered.

The above desirable ship design supporting system further includes a consideration item calculating section for calculating consideration items as ship propulsion performance, a hull strength, hull vibration, weight, a gravity center position, a welding length, bow wave impact or a longitudinal strength of the ship to be built, based on the general arrangement model, a display section for displaying the consideration items; and an input section which is operated by the operator. The model producing and changing section changes the general arrangement model based on an operation of the input section.

Preferably, the above ship design supporting system further includes a cost calculating section for calculating a cost of the ship to be built, based on the general arrangement model; and a display section for displaying the cost.

Preferably, the above ship design supporting system further includes a 2-dimensional data generating section for generating 2-dimensional data of drawings of the ship based on the general arrangement model after the change based on the final line plan data; and an output section for outputting the drawings shown by the two dimension data.

In the second view of the present invention, a ship building method includes producing a general arrangement model which contains a hull structure model as a 3D-dimensional model of a hull structure and an equipment apparatus model as a 3D-dimensional model of an equipment apparatus; changing the general arrangement model based on final line plan data showing a built ship shape; and manufacturing the ship based on the general arrangement model which has been changed based on the final line plan data.

Preferably, the producing the general arrangement model is started before the final line plan data is completed.

In the third view of the present invention, a ship design support program includes storing general arrangement model data describing a general arrangement model which contains a hull structure model as a 3D-dimensional model of a hull structure and an equipment apparatus model as a 3D-dimensional model of an equipment apparatus; and changing the general arrangement model based on the final line plan data showing a built ship shape.

According to the present invention, the ship design supporting system and the ship building method are provided in which a time from start of the design to completion can be reduced.

**Brief Description of the Drawings**

The above-mentioned objects, other objects, effects and features of the present invention will be clarified by the descriptions of the embodiments in linkage with the attached drawings.

FIG. 1 is a block diagram showing an apparatus configuration of a ship design supporting system according to a first embodiment of the present invention;
FIG. 2 is a functional block diagram showing the ship design supporting system and a data server according to the first embodiment;
FIG. 3 shows a block model registered in a block model library;
FIG. 4 shows a bulkhead model registered in a strength member model library;
FIG. 5 shows a large rib model and a support pillar model, which are registered in the strength member model library;
FIG. 6 shows an equipment apparatus model registered in an equipment apparatus model;
FIG. 7 is a flowchart of a ship building method according to the first embodiment;
FIG. 8 is a conceptual view of an initial general arrangement data;
FIG. 9 shows a thrust - shaft system module produced by combining the equipment apparatus models;
FIG. 10 is a conceptual view of an example of a modification process of a hull structure model caused by a replacement of a ship body line plan;
FIG. 11 is a conceptual view of another example of the modification process of the hull structure model caused by the replacement of the ship body line plan; and
FIG. 12 is a perspective view showing an arrangement change process of the equipment apparatus model caused by the displacement of the ship body line plan.

**Description of Embodiments**

Hereinafter, a ship design supporting system and a ship building method according to embodiments of the present invention will be described with reference to the attached drawings.

[First Embodiment]

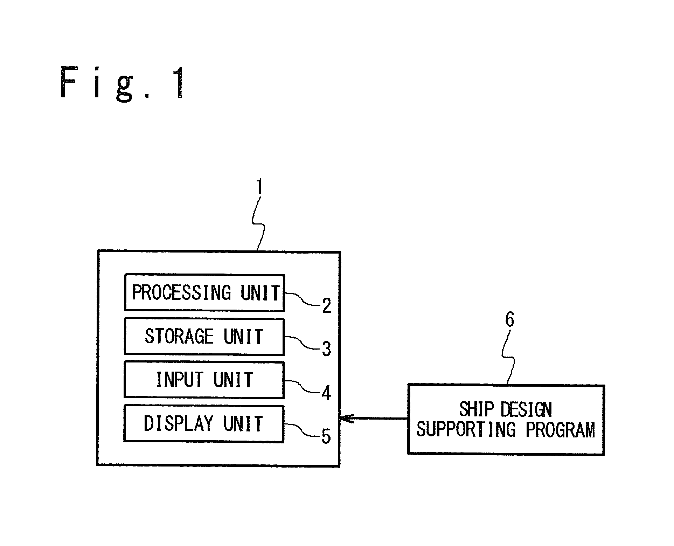

A ship design supporting system 1 according to a first embodiment of the present invention will be described below with reference to FIG. 1. The ship design supporting system 1 is a computer that contains a calculation processing unit 2, a storage unit 3, an input unit 4 and a display unit 5. The calculation processing unit 2 is a CPU. The storing unit 3 includes a main memory unit such as a semiconductor storage unit and an auxiliary storage unit such as a hard disc unit. The input unit 4 includes a keyboard and a mouth. The display unit 5 is a liquid crystal display. A ship design support program 6 is installed in the ship design supporting system 1. The ship design support program 6 may be provided in a state in which the program 6 is recorded in a computer-readable recording medium (for example, CD-ROM) or may be provided through a network.

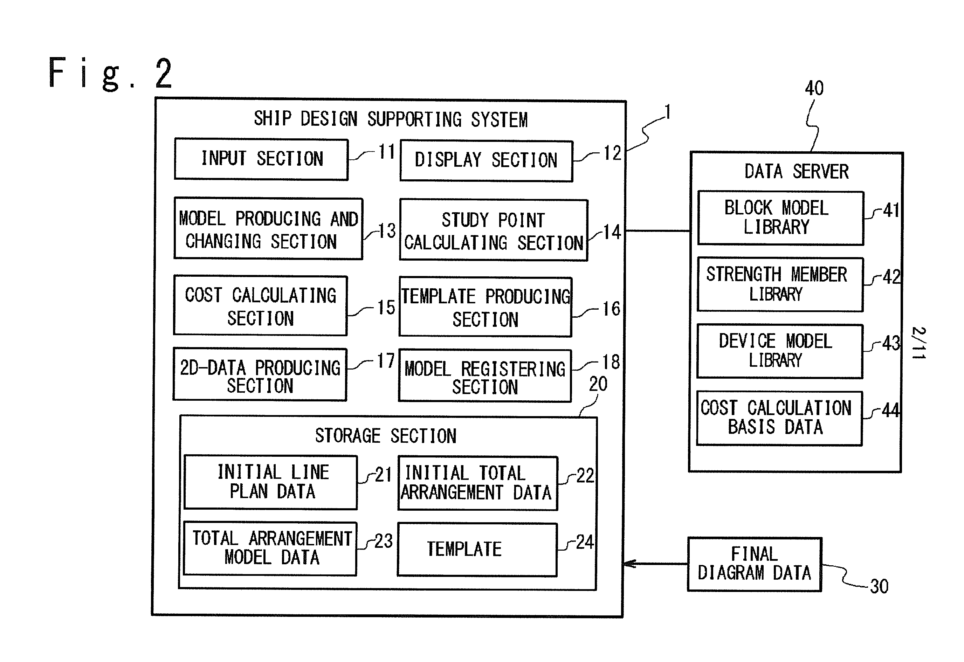

With reference to FIG. 2, when the ship design support program 6 is executed, the ship design supporting system 1 attains an input section 11, a display section 12, a model producing and changing section 13, a study point calculating section 14, a cost calculating section 15, a template producing section 16, a 2-dimensional data producing section 17, a model registering section 18 and a storage section 20. The model producing and changing section 13 produces and changes a digital mockup (DMU). The DMU is a 3-dimensional model (3D model) produced by using a 3-dimensional CAD (Computer Aided Design) tool. It is possible to compare and consider the appearance, the internal configuration, the operation and the like of a product that has been modeled as the DMU by using a simulation software (for example, the general ship, equipment apparatuses installed in the ship, a hull structure of the ship or a strength members configuring the hull structure). As described later, the storage unit 20 stores an initial line plan data 21, an initial general arrangement data 22, a general arrangement model data 23, a template 24 and a final line plan data 30. The ship design supporting system 1 is connected to a data server 40.

The data server 40 stores a block model library 41, a strength member model library 42, an equipment apparatus model library 43 and a cost calculation basis data 44. The block model library 41, the strength member model library 42, the equipment apparatus model library 43 and the cost calculation basis data 44 are shared between the ship design supporting system 1 and other ship design supporting systems (that are not shown) connected to the data server 40. When the data is not shared, the block model library 41, the strength member model library 42, the equipment apparatus model library 43 and the cost calculation basis data 44 may be stored in the storage unit 20.

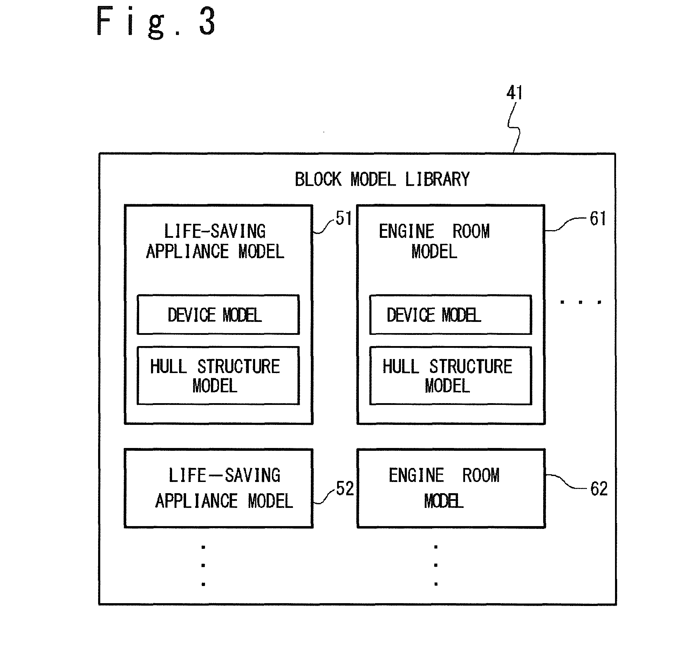

With reference to FIG. 3, a plurality of block models, which include a life saving appliance model 51, a life saving appliance model 52, an engine room model 61 and an engine room model 61, are registers in the block model library 41. That is, the data server 40 stores the data of the plurality of block models. The block model is one DMU of a block of a built ship or an already produced DMU. For example, the life saving appliance model 51 and the engine room model 61 are the DMUs of a life saving appliance block and an engine room block in the built ship. The life saving appliance model 52 and the engine room model 62 are the DMUs of a life saving appliance block and an engine room block of another built ship. The life saving appliance model 51 includes an equipment apparatus model as the DMUs of a lifeboat and a lifting apparatus of the lifeboat and a hull structure model as the DMU of a hull structure. The engine room model 61 includes the equipment apparatus models as the DMUs of an engine and its peripheral equipment and a hull structure model as the DMU of a hull structure. As the block model, there are a case that only the equipment apparatus model is included, a case that the equipment apparatus model and the hull structure model are included, and a case that only the hull structure model is included.

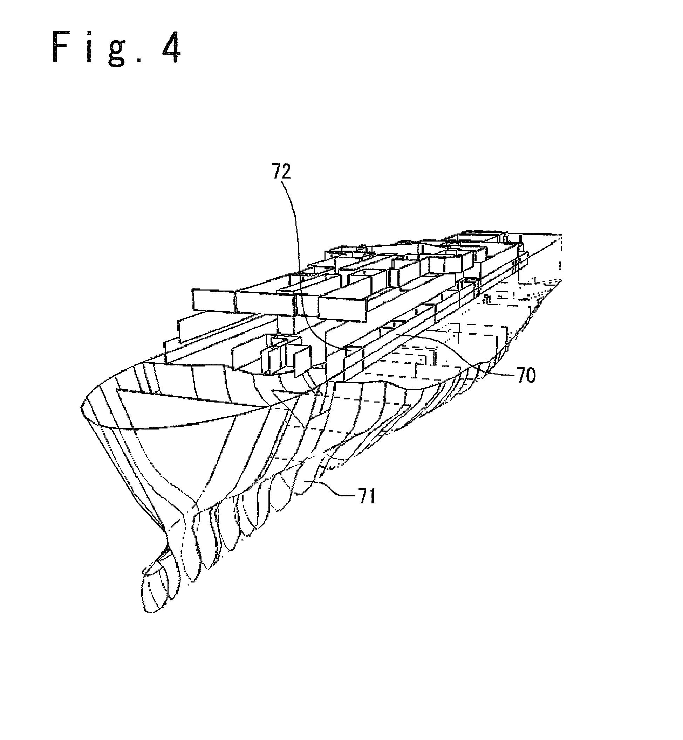

With reference to FIG. 4, a plurality of bulkhead models are registered in the strength member model library 42 as a plurality of strength member models. That is, the data server 40 stores the data of the plurality of bulkhead models. The plurality of bulkhead models are as the DMU of the bulkheads configuring the hull structure model of the built ship, and include bulkhead models 70 to 72. The bulkhead model 70 is the DMU of a longitudinal bulkhead. The bulkhead model 71 is the DMU of a lateral bulkhead. The bulkhead model 72 is the DMU of a partial bulkhead.

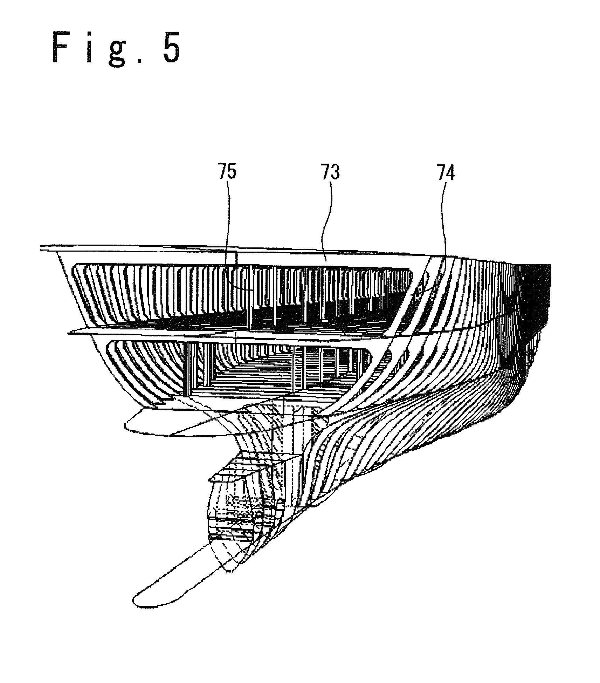

With reference to FIG. 5, a plurality of large rib models and support pillar models are registered in the strength member model library 42 as the plurality of strength member models. That is, the data server 40 stores the data of the plurality of large rib models and support pillar models. The plurality of large rib models and support pillars are the DMUs of large ribs and support pillars, which configure the hull structure of the built ship. The plurality of large rib models and support pillar models include a large rib model 73, a large rib model 74 and a support pillar model 75. The large rib model 73 is the DMU of a beam. The large rib model 74 is the DMU of a frame. The support pillar model 75 is the DMU of a support pillar.

The DMUs of a deck and an outer plate may be registered in the strength member model library 42 as the strength member models.

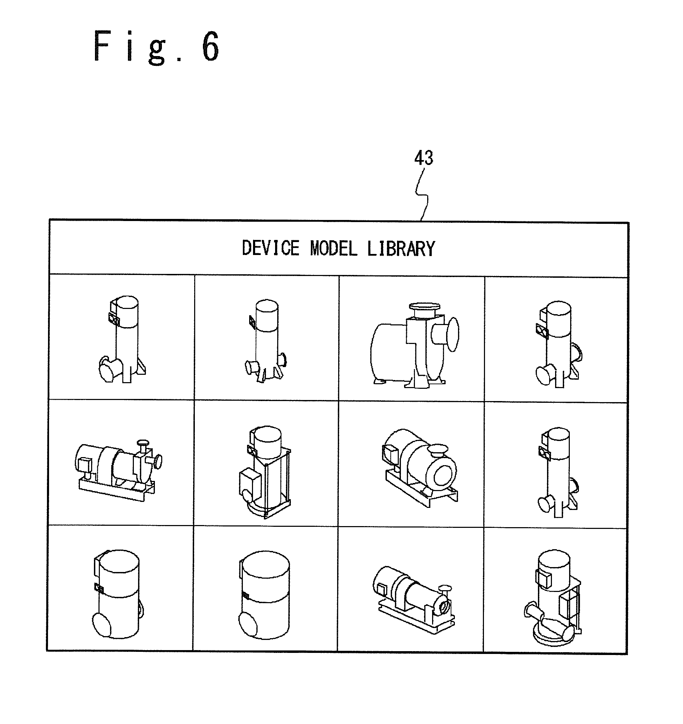

With reference to FIG. 6, a plurality of equipment apparatus models are registered in the equipment apparatus model library 43. That is, the data server 40 stores the data of the plurality of equipment apparatus models. The equipment apparatus model is the DMU of a proven general equipment apparatus.

The cost calculation basis data 44 includes basis data for calculating a cost of the ship to be built, such as a cost of the equipment apparatus, a cost per steel unit weight, a cost per unit welding length and the like.

The ship design supporting system 1 is used in the ship building method according to the present embodiment.

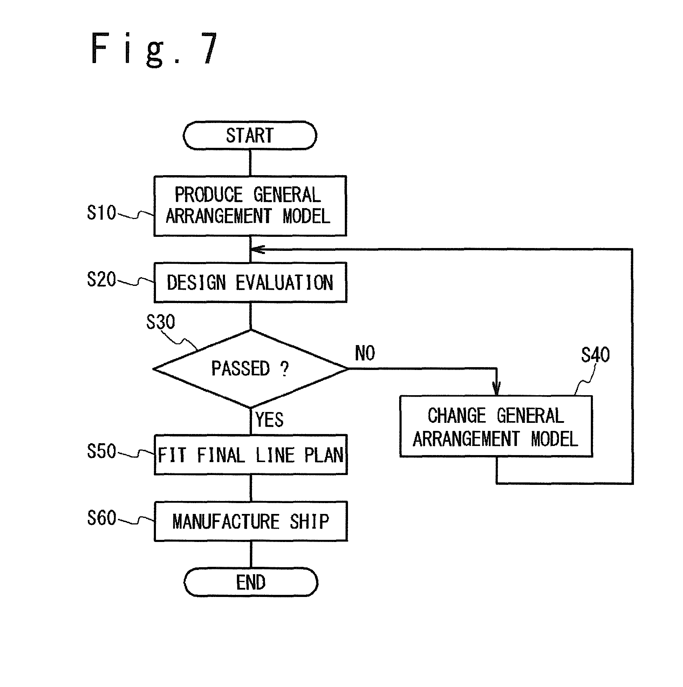

With reference to FIG. 7, the ship building method according to the present embodiment contains a general arrangement model production step S10, a design evaluation step S20, a pass or rejection determination step S30, a general arrangement model change step S40, a final line plan engagement step S50 and a ship building step S60. At the general arrangement model production step S10, a general arrangement model is produced which includes the hull structure model as the DMU of the hull structure and the equipment apparatus models as the DMUs of the equipment apparatus. At the design evaluation step S20, the design is evaluated on the basis of the general arrangement model. At the pass or rejection determination step S30, a pass or rejection is determined on the basis of the result of the design evaluation step S20. If the rejection is determined, the general arrangement model is changed at the general arrangement model change step S40. Until the pass is determined at the pass or rejection determination step S30, the steps S20, S30 and S40 are repeated. If the pass is determined at the pass or rejection determination step S30, at the final line plan engagement step S50, the general arrangement model is changed on the basis of an independently designed final line plan. At the ship building step S60, the ship is built on the basis of the general arrangement model changed at the step S50.

The steps S10 to S60 will be described below in detail, by using an example of designing and building a ferry boat. However, the ship design supporting system 1 and the ship building method according to the present embodiment can be used to design and build various ships including a cargo ship and a passenger ship.

(Step S10)

The general arrangement model production step S10 will be now described below. The storage unit 20 stores the initial line plan data 21 and the initial general arrangement data 22, which are provided externally. The initial line plan data 21 represents a previously designed standard type ship or a proven ship of building. The initial general arrangement data 22 indicates the arrangement of the blocks.

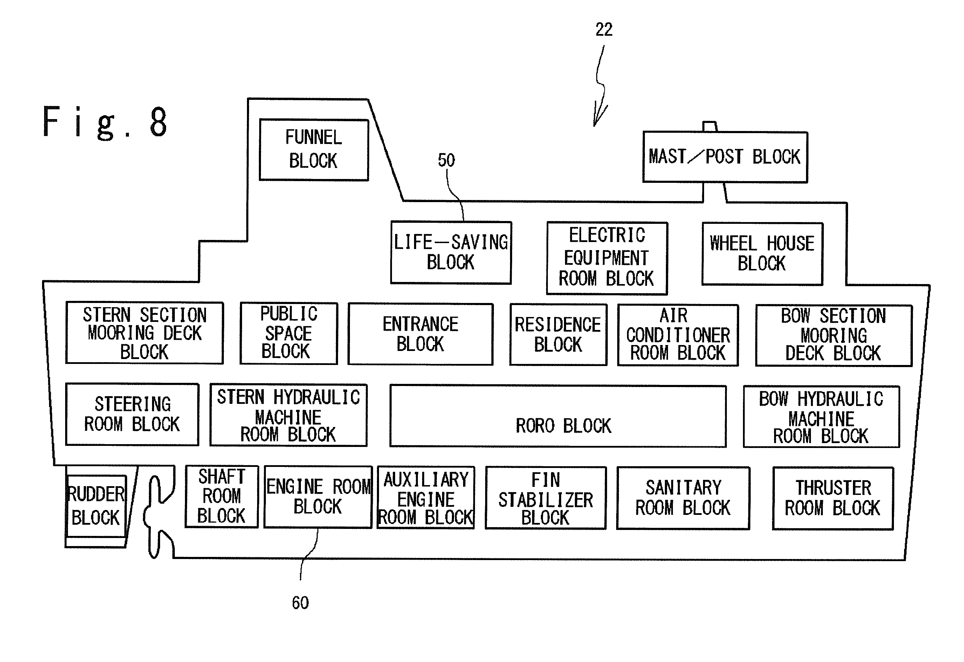

With reference to FIG. 8, the initial general arrangement data 22 indicates the arrangement of a plurality of blocks, which include a life saving appliance block 50 and an engine room block 60. It should be noted that a RoRo (Roll-on/Roll-off) block in FIG. 8 includes a lamp and an automobile deck on which an automobile is stopped and landed. It should be noted that since a tank, a furniture, a pipe, a duct and an electric wire are dispersedly arranged, their arrangement has not been specified by the initial general arrangement data 22.

The model producing and changing section 13 selects a block model as a candidate of the DMU of the block from the block model library 41, on the basis of the operation of the input section 11 executed by an operator (for example, a designer). For example, the model producing and changing section 13 selects the life saving appliance model 51 as the candidate of the DMU of the life saving appliance block 50 and selects the engine room model 61 as the candidate of the DMU of the engine room block 60.

The model producing and changing section 13 selects the equipment apparatus model as the DMU of the tank, the furniture, the pipe, the duct and the electric wire from the equipment apparatus model library 43, on the basis of the operation of the input section 11 executed by the operator and arranges the selected equipment apparatus model. Here, the model producing and changing section 13 may newly produce the equipment apparatus models as the DMUs of the tank, the furniture, the pipe, the duct and the electric wire, on the basis of the operation of the input section 11 executed by the operator.

The model producing and changing section 13 produces the general arrangement model to include the life saving appliance model 51, the engine room model 61, and the equipment apparatus models of a tank, a furniture, a pipe, a duct and an electric wire, on the basis of the initial line plan data 21 and the initial general arrangement data 22. As a result, the equipment apparatus models of the general arrangement model include the equipment apparatus models such as the equipment apparatus model of a life saving appliance model 51, the equipment apparatus model of the engine room model 61, and the equipment apparatus models of the tank, the furniture, the pipe, the duct and the electric wire, and the hull structure model of the general arrangement model includes the hull structure model of the engine room model 61. The storage unit 21 stores the general arrangement model data 23 that describes the general arrangement model. It should be noted that when the general arrangement model is produced, the model producing and changing section 13 changes the hull structure model included in the block model such as the engine room model 61, on the basis of the initial line plan data 21.

When the proper block model does not exist in the block model library 41, the new block model is produced, and the produced block model may be used as the candidate of the DMU of the block. For example, the model producing and changing section 13 produces a block model by changing a parameter of the block model registered in the block model library 41, on the basis of the operation of the input section 11 executed by the operator. As parameters, there are the main portion of the ship body, the number of furnitures, a deck area and the like. In this case, the block model can be easily produced.

Also, when the proper block model does not exist in the block model library 41, the new block model may be produced without using the block model registered in the block model library 41. For example, when the proper engine room block model does not exist in the block model library 41, the engine room block model produced by newly producing the engine room block model is used as the candidate of the DMU of the engine room block 60, instead of selecting the engine room model 61 as the candidate of the DMU of the engine room block 60.

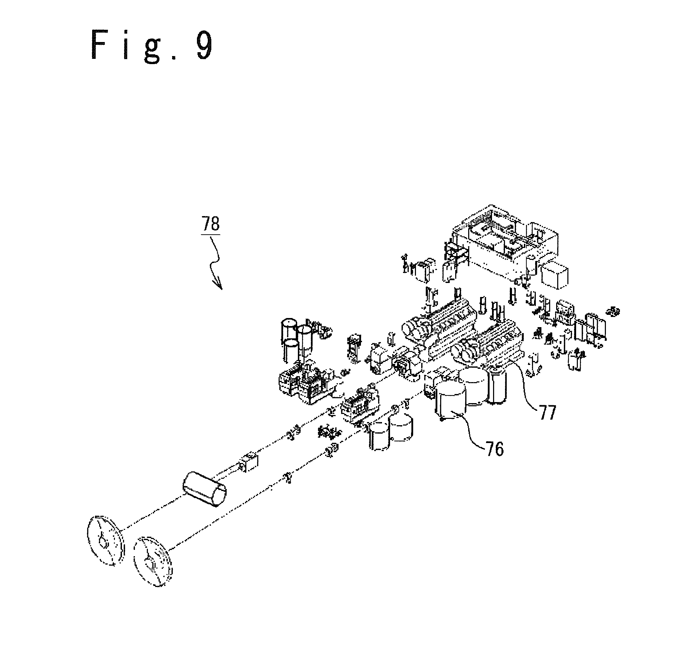

With reference to FIG. 9, the process in this case will be described below. The model producing and changing section 13 selects equipment apparatus models 77 and 76 as the DMUs of the engine and its peripheral units from the equipment apparatus model library 43, on the basis of the operation of the input section 11 executed by the operator. The model producing and changing section 13 produces a thrust - shaft system module 78, which includes the equipment apparatus models 77 and 76, on the basis of the operation of the input section 11 executed by the operator. The model producing and changing section 13 produces the hull structure model as the DMU of the hull structure, on the basis of the operation of the input section 11 executed by the operator. The model producing and changing section 13 may select the strength member model from the strength member model library 42 and produce the hull structure model to include the selected strength member model. Or, the model producing and changing section 13 may produce the strength member model and produce the hull structure model to include the produced strength member model. The model producing and changing section 13 produces the engine room block model to include the produced hull structure model and the thrust - shaft system module 78, on the basis of the operation of the input section 11 executed by the operator.

In this case, the template producing section 16 produces a template 24 in which a producing step (producing procedure) of the thrust - shaft system module 78 or the engine room block model is registered. In the template 24, the knowhow such as experience knowledge and formal knowledge are preferred to be registered, in relation to the producing step of the thrust - shaft system module 78 or the engine room block model. The storage unit 20 stores the template 24. The model producing and changing section 13 can easily produce the new thrust - shaft system module or engine room block model, by using the template 24 when the new thrust - shaft system module or engine room block model is produced. It should be noted that if the template 24 is stored in the data server 40, another ship design supporting system 1 (that is not known) can use the template 24.

In this case, the model registering section 18 registers the produced engine room block model in the block model library 41. That is, the data of the produced engine room block model can be stored in the data server 40. Thus, the engine room block model produced at this time can be used in designing a ship from a next time.

(Step S20)

The design evaluation step S20 will be described below. The study point calculating section 14 calculates consideration items such as thrust performance, ship body strength, ship body vibration, weight, a gravity center position, welding length, stem wave impact, and longitudinal strength of a ship to be build, on the basis of the general arrangement model. The cost calculating section 15 calculates the cost of the ship to be built, on the basis of the general arrangement model and the cost calculation basis data 44. The display section 12 displays the general arrangement model, the consideration items and the costs. The operator (designer) evaluates the design from the viewpoint of client need, the viewpoint of public criteria, the viewpoint of internal references of a shipbuilding company and the like, on the basis of the general arrangement model, the consideration items and the costs, which are displayed on the display section 12.

(Step S30)

The pass or rejection determination step S30 will be described below. The operator (designer) determines the pass or rejection on the basis of the result of the design evaluation step S20.

(Step S40)

The general arrangement model change step S40 will be described below. The model producing and changing section 13 changes the general arrangement model, on the basis of the operation of the input section 11 executed by the operator (designer). For example, the model producing and changing section 13 changes the hull structure model of the general arrangement model in such a way that the consideration item has a target value, by moving the equipment apparatus model included in the general arrangement model to change the gravity center position, by substituting another equipment apparatus model for the general arrangement model included in the general arrangement model, or by carrying out removal, positional change, and addition of the strength member model.

By repeating the steps S20 to S40, it is possible to increase the completion level of the general arrangement model in correspondence to the client need, and improve the design quality. Therefore, it is possible to attain mass customization design corresponding to the client need.

(Step S50)

The final line plan engagement step S50 will be described below. The storage unit 20 stores the final line plan data 30 provided externally. The final line plan data 30 represents the ship shape of the ship to be built. The final line plan data 30 is produced, for example, by using the ship design apparatus described in Patent Literature 1 (JP 2004-9858A). The model producing and changing section 13 automatically changes the general arrangement model on the basis of the final line plan data 30. The general arrangement model is updated so as to describe the changed general arrangement model data 23 and stored.

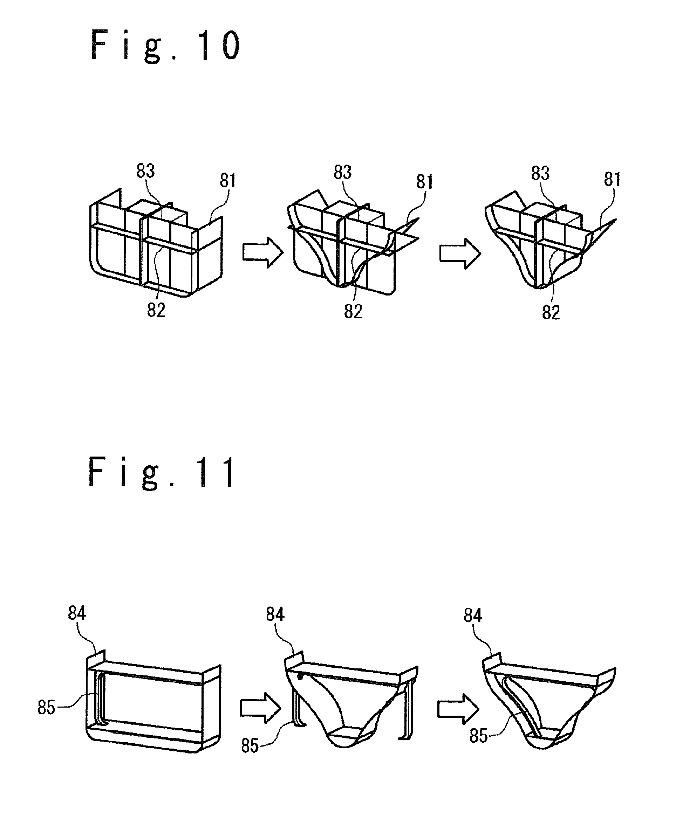

With reference to FIG. 10, the final line plan engagement step S50 will be described below. Here, an example is described in which the hull structure model of the general arrangement model is configured from a plurality of strength member models, which include an outer plate model 81, a deck model 82 and a transverse bulkhead model 83. The outer plate model 81, the deck model 82 and the transverse bulkhead model 83 are the DMUs of the outer plate, the deck and the transverse bulkhead, respectively. Here, the deck in which the deck model 82 is modeled and the transverse bulkhead in which the transverse bulkhead model 83 is modeled are welded to the outer plate in which the outer plate model 81 is modeled. The model producing and changing section 13 automatically deforms the outer plate model 81 on the basis of the final line plan data 30 and automatically deforms the deck model 82 and the transverse bulkhead model 83 so that they follow the deformation of the outer plate model 81. For example, the model producing and changing section 13 removes the portions, which are the portions of the deck model 82 and the transverse bulkhead model 83 and stick out to the outside from the outer plate model 81 after the deformation. It should be noted that when a gap generates between the outer plate model 81 after the deformation and the deck model 82 and a gap generates between the outer plate model 81 after the deformation and the transverse bulkhead model 83, the deck model 82 and the transverse bulkhead model 83 are extended to be brought into contact with the outer plate model 81 after the deformation.

With reference to FIG. 11, the final line plan engagement step S50 will be described below. Here, an example will be described in which the hull structure model of the general arrangement model is configured by the plurality of strength member models, which include an outer plate model 84 and a frame model 85. The outer plate model 84 and the frame model 85 are the DMUs of an outer plate and a frame, respectively. Here, the frame in which the frame model 85 is modeled is welded to the outer plate in which the outer plate model 84 is modeled. The frame model 85 extends within a perpendicular plane along the outer plate model 84. The model producing and changing section 13 automatically deforms the outer plate model 84 on the basis of the final line plan data 30 and automatically deforms the frame model 85 so that the frame model 85 follows the deformation of the outer plate model 84. For example, the model producing and changing section 13 deforms the frame model 85 so that the frame model 85 extends within the above perpendicular plane along the outer plate model 84 after the deformation.

At the final line plan engagement step S50, a longitudinal bulkhead model, a partial bulkhead, a big rib model (beam model) and a support pillar model, which are included in the hull structure model of the general arrangement model, may be automatically deformed to follow the deformation of the outer plate model.

The model producing and changing section 13 may automatically change or may not change the arrangement of the equipment apparatus model on the basis of the hull structure model after the deformation. On the basis of the operation of the input section 11 executed by the operator, it is preferable to set whether or not the automatic change in the arrangement of the equipment apparatus model is executed.

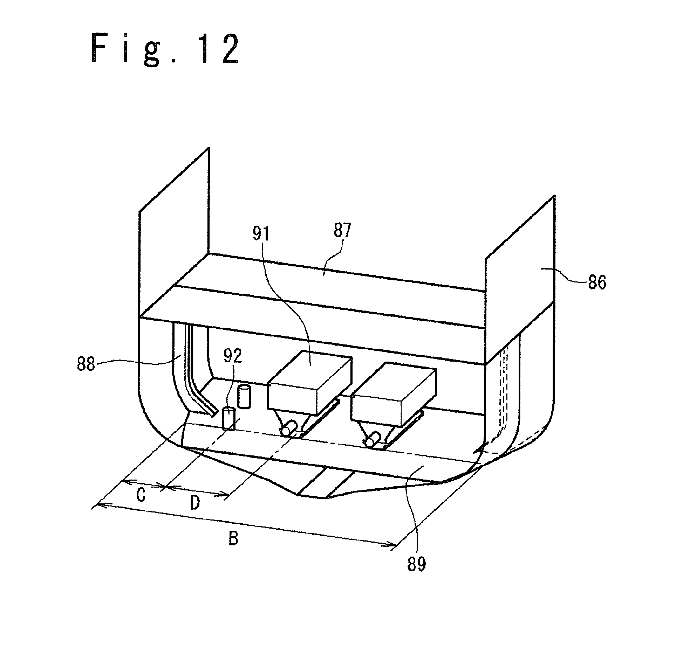

With reference to FIG. 12, a process for automatically changing the arrangement of the equipment apparatus model will be described on the basis of the hull structure model after the deformation. Here, a case will be described in which the hull structure model of the general arrangement model is configured from the plurality of strength member models, which include an outer plate model 86, a deck model 87, a frame model 88 and a double bottom model 89, and the general arrangement model includes a main engine model 91 and a pump model 92 as the equipment apparatus model. The outer plate model 86, the deck model 87, the frame model 88, the double bottom model 89, the main engine model 91 and the pump model 92 are the DMUs of an outer plate, a deck, a frame, a double bottom, a main engine and the pump, respectively. Here, the deck in which the deck model 87 is modeled, the frame in which the frame model 88 is modeled and the double bottom in which the double bottom model 89 is modeled are welded to the outer plate in which the outer plate model 86 is modeled. The main engine model 91 and the pump model 92 are arranged on the double bottom model 89. A width in a ship width direction of the double bottom model 89 at a position of the pump model 92 is indicated by B, and a distance in the ship width direction between the ship body helm side and the pump model 92 is indicated by C, and a distance in the ship width direction between the pump model 92 and the main engine model 91 is indicated by D. The distance C corresponds to a relative position between the ship body helm side and the pump model 92. The distance D corresponds to a relative position between the main engine model 91 and the pump model 92.

The model producing and changing section 13 specifies the equipment apparatus model whose arrangement is automatically changed in response to the deformation of the hull structure model, on the basis of the operation of the input section 11 executed by the operator (designer). Hereinafter, a case will be described in which the main engine model 91 is not specified and the pump model 92 is specified.

The model producing and changing section 13 sets an arrangement change rule of the pump model 92, on the basis of the operation of the input section 11 executed by the operator (designer). The storage unit 20 stores the arrangement change rule. For example, a relation between the distance D and the width B is set by the following equation:

$$D = k \cdot B + r$$

The distance D is represented by a primary expression of the width B. Here, the values of the distance D and the width B before the hull structure model is automatically deformed on the basis of the final line plan data 30 are assumed to be D1 and B1, respectively. Then, k and r are actual constants that satisfy the following equation:

$$D1 = k \cdot B1 + r.$$

The model producing and changing section 13 automatically deforms the outer plate model 86 on the basis of the final line plan data 30 and automatically deforms the deck model 87, the frame model 88 and the dual bottom model 89 to follow the deformation of the outer plate model 86. As a result, the value of the width B is changed to B2.

The model producing and changing section 13 changes the arrangement of the pump model 92 so that the distance D has a value D2. The value D2 is represented by the following equation:

$$D2 = k \cdot B2 + r$$

As another example, a case will be described in which the arrangement change rule of the pump model 92 is given by the following equation:

$$C = m \cdot B + s$$

The distance C is represented by a primary equation of the width B. Here, the values of the distance C and the width B before the hull structure model is automatically deformed on the basis of the final line plan data 30 are assumed to be C1 and B1, respectively.

Then, m and s are actual constants that satisfy the following equation:

$$C1 = m \cdot B1 + s.$$

Here, the actual constant may be zero (the value of the distance C is fixed to an actual constant s).

In this case, the model producing and changing section 13 changes the arrangement of the pump model 92 so that the distance C has a value C2. The value C2 is represented by the following equation:

$$C2 = m \cdot B2 + s$$

It should be noted that the distance C may be fixed to the actual constant s.

As still another example, a case will be described in which the arrangement change rule of the pump model 92 is given by the following equations:

$$C + D = n \cdot B + t$$

$$C/D = u$$

Here, the values of the distance C, the distance D and the width B before the hull structure model is automatically deformed on the basis of the final line plan data 30 are assumed to be C1, D1 and B1, respectively. Then, n, t and u are actual constants that satisfy the following equations:

$$C1 + D1 = n \cdot B + t$$

$$C1/D1 = u$$

In this case, the model producing and changing section 13 changes the arrangement of the pump model 92 so that the distance C has a value C2 and the distance D has a value D2. The value C2 and the value D2 are represented by the following equations:

$$C2 + D2 = n \cdot B + t$$

$$C2/D2 = u$$

As mentioned above, an example will be described in which the arrangement of the equipment apparatus model is changed on the basis of the change in the width B when the hull structure model is deformed on the basis of the final line plan data 30. The arrangement of the equipment apparatus model may be changed on the basis of the change in the typical length of the hull except the width B when the hull structure model is deformed on the basis of the final line plan data 30.

(Step S60)

The ship building step S60 will be described below. The ship is built on the basis of the general arrangement model obtained as the result of the final line plan engagement step S50. Here, a 2-dimensional data producing section 17 generates a 2-dimensional data of drawings of a ship to be built on the basis of the general arrangement model. For example, the 2-dimensional data represents a plan view of a stem mooring deck block. The 2-dimensional data is stored in the storage unit 20, and the drawing represented by the 2-dimensional data is displayed by the display section 12 or printed by a printer that is not shown. The 2-dimensional data producing section 17 can be used to automatically generate the 2-dimensional data of the drawing from the general arrangement model as a 3D model.

It should be noted that the ship design supporting system 1 may output the general arrangement model data 23 to the outside without generating the 2-dimensional data and then build the ship on the basis of the general arrangement model data 23 outputted to the outside.

According to the present embodiment, after the increase in the completion level of the general arrangement model, the general arrangement model is changed on the basis of the final line plan data 30. Thus, the final line plan data 30 can be generated in parallel to the steps S10 to S40 of generating the general arrangement model and making increasing its completion high. The fact that the final line plan data 30 is generated in parallel to the steps S20 to S40 indicates that, for example, the general arrangement model production step S10 is started prior to the completion of the final line plan data 30. Thus, the necessary time from the start of the design to the completion is made short.

Moreover, the libraries 41 to 43 in which the previously produced DMUs and the DMUs of the built ship are registered are used to carry out the design. Thus, the necessary time from the start of the design to the completion is made short.

Also, the general arrangement model can be easily produced and changed and the general arrangement models before and after the change can be displayed on the display section 12 and checked thereby. Thus, the ship design supporting system 1 is preferable for the presentation for a client.

As mentioned above, the present invention has been described by referring to the embodiments. However, the present invention is not limited to the above-mentioned embodiments. Various modifications can be performed on the above-mentioned embodiments.

For example, when the block model is produced at the step S10, the model registering section 18 is preferred to register the block model in the block model library 41 after the determination at the step S30 is passed. In this case, until the determination at the step S30 is passed, the steps S20 to S40 are repeated, and the block model in the state in which the completion level is made high is registered.

Also, the block model of the block model library 41, the strength member model of the strength member model library 42, and the equipment apparatus model of the equipment apparatus model library 43 are preferred to be classified into a plurality of groups on the basis of the scale of the ship. The operator can quickly select the suitable model from the group corresponding to the scale of the ship to be built. Moreover, when the operator operates the input section 11 and specifies the scale of the ship to be built, the display section 12 is preferred to display only the group corresponding to the specified scale.

This application claims a priority based on Japanese Patent Application No. JP 2010-225695 filed on October 5, 2010, and the disclosure thereof is incorporated herein by reference.

**Claims**

1. A ship design supporting system comprising:

   storage means for storing general arrangement model data describing a general arrangement model which contains a hull structure model as a 3-dimensional model of a hull structure and an equipment apparatus model as a 3-dimensional model of an equipment apparatus; and
   model producing and changing means for changing the general arrangement model based on a final line plan data which shows a built ship shape.

2. The ship design supporting system according to claim 1, wherein the hull structure model comprises:

   an outer plate model as a 3-dimensional model of an outer plate; and
   a strength member model as 3-dimensional model of a bulkhead, a big rib, a support pillar, a deck or a double bottom, and

wherein said model producing and changing means changes the outer plate model based on the final line plan data and changes the strength member model to follow the change of the outer plate model.

3. The ship design supporting system according to claim 2, wherein the strength member model contains a first strength member model as a 3-dimensional model of the bulkhead or the deck, and wherein said model producing and changing means removes a portion of the first strength member model which sticks out from the outer plate model after the change.

4. The ship design supporting system according to claim 2 or 3, wherein the strength member model contains a second strength member model as a 3-dimensional model of a frame extending along said outer plate, and wherein said model producing and changing means changes the second strength member model such that said second strength member model extends along the outer plate model after the change.

5. The ship design supporting system according to any of claims 1 to 4, further comprising input means which is operated by an operator, wherein said model producing and changing means:

   selects a first block model from a block model library as a candidate of a 3-dimensional model of a first block of the ship to be built based on an operation of said input means, and produces the general arrangement model such that the general arrangement model contains the first block model, based on initial general arrangement data which shows initial line plan data representing the ship shape and representing an arrangement of the block, wherein the first block model contains:

   a first block hull structure model as a 3-dimensional model of the hull structure; and a first block equipment apparatus model as a 3D-dimensional model of an equipment apparatus, and wherein the hull structure model contains the first block hull structure model, and the equipment apparatus model contains the first block equipment apparatus model.

6. The ship design supporting system according to any of claims 1 to 4, further comprising input means which is operated by an operator, wherein said model producing and changing means:

   selects a first block model from a block model library as a candidate of a 3D-dimensional model of a first block of the ship to be built based on an operation of said input means, selects a second block equipment apparatus model as a 3D-dimensional model of an equipment apparatus from an equipment apparatus model library based on an operation of said input means, produces a second block hull structure model as a 3D-dimensional model of the hull structure based on an operation of said input means, produces a second block model which contains the second block hull structure model and the second block equipment apparatus model as a candidate of a 3D-dimensional model of a second block of said ship to be built, based on an operation of said input means, and produces the general arrangement model such that the general arrangement model contains the first block model and the second block model, based on initial line plan data showing the shape of said ship and initial general arrangement data showing the arrangement of blocks, wherein the first block model contains a first block equipment apparatus model as a 3D-dimensional model of the equipment apparatus, wherein the hull structure model contains the second block hull structure model, and wherein the equipment apparatus model contains the first block equipment apparatus model and the second block equipment apparatus model.

7. The ship design supporting system according to claim 6, further comprising:

   model registering means for registering the second block model on said block model library.

8. The ship design supporting system according to claim 6 or 7, further comprising:

   template producing means for producing a template in which a producing process of the second block model is registered.

9. The ship design supporting system according to any of claims 1 to 4, further comprising:

   consideration item calculating means for calculating consideration items as ship propulsion performance, a hull strength, hull vibration, weight, a gravity center position, welding length, bow wave impact or a longitudinal strength of said ship to be built, based on the general arrangement model, display means for displaying the consideration items; and input means which is operated by the operator,

wherein said model producing and changing means changes the general arrangement model based on an operation of said input means.

10. The ship design supporting system according to any of claims 1 to 4, further comprising:

cost calculating means for calculating a cost of said ship to be built, based on the general arrangement model; and
display means for displaying the cost.

11. The ship design supporting system according to any of claims 1 to 10, further comprising:

2-dimensional data generating section for generating 2-dimensional data of drawings of said ship based on the general arrangement model after the change based on the final line plan data; and
output means for outputting the drawings shown by the two dimension data.

12. A ship building method comprising:

producing a general arrangement model which contains a hull structure model as a 3D-dimensional model of a hull structure and an equipment apparatus model as a 3D-dimensional model of equipment apparatus;
changing the general arrangement model based on final line plan data showing a shape of a ship to be built; and
manufacturing said ship based on the general arrangement model which has been changed based on the final line plan data.

13. The ship building method according to claim 12, wherein said producing the general arrangement model is started before the final line plan data is completed.

14. A ship design supporting program comprising:

storing general arrangement model data describing a general arrangement model which contains a hull structure model as a 3D-dimensional model of a hull structure and an equipment apparatus model as a 3D-dimensional model of equipment apparatus; and
changing the general arrangement model based on final line plan data showing a shape of a ship to be built.

15. A ship which is designed and built by using said ship design supporting system according to any of claims 1 to 11.

16. A ship which is built by said ship building method according to claim 12 or 13.

# Fig. 1

```
┌─────────────────────────────────┐ 1
│                                 │
│  ┌───────────────────────┐      │
│  │ PROCESSING UNIT       │──── 2│
│  └───────────────────────┘      │
│  ┌───────────────────────┐      │
│  │   STORAGE UNIT        │──── 3│
│  └───────────────────────┘      │
│  ┌───────────────────────┐      │
│  │    INPUT UNIT         │──── 4│
│  └───────────────────────┘      │
│  ┌───────────────────────┐      │
│  │   DISPLAY UNIT        │──── 5│
│  └───────────────────────┘◄─────┤
└─────────────────────────────────┘
```

6

┌─────────────────────────┐
│    SHIP DESIGN          │
│ SUPPORTING PROGRAM      │
└─────────────────────────┘

# Fig. 2

**SHIP DESIGN SUPPORTING SYSTEM** ~1

| INPUT SECTION ~11 | DISPLAY SECTION ~12 |

| MODEL PRODUCING AND CHANGING SECTION ~13 | STUDY POINT CALCULATING SECTION ~14 |

| COST CALCULATING SECTION ~15 | TEMPLATE PRODUCING SECTION ~16 |

| 2D-DATA PRODUCING SECTION ~17 | MODEL REGISTERING SECTION ~18 |

**STORAGE SECTION** 20

| INITIAL LINE PLAN DATA ~21 | INITIAL TOTAL ARRANGEMENT DATA ~22 |

| TOTAL ARRANGEMENT MODEL DATA ~23 | TEMPLATE ~24 |

**DATA SERVER** 40

- BLOCK MODEL LIBRARY ~41
- STRENGTH MEMBER LIBRARY ~42
- DEVICE MODEL LIBRARY ~43
- COST CALCULATION BASIS DATA ~44

FINAL DIAGRAM DATA ~30

# Fig. 3

41

BLOCK MODEL LIBRARY

LIFE-SAVING APPLIANCE MODEL — 51

DEVICE MODEL

HULL STRUCTURE MODEL

ENGINE ROOM MODEL — 61

DEVICE MODEL

HULL STRUCTURE MODEL

· · ·

LIFE—SAVING APPLIANCE MODEL — 52

ENGINE ROOM MODEL — 62

# Fig. 4

# F i g . 5

# Ｆｉｇ．6

43

DEVICE MODEL LIBRARY

# Fig. 7

```
                    ┌──────────┐
                    │  START   │
                    └────┬─────┘
                         │
        ┌────────────────┴────────────────┐
  S10   │   PRODUCE  GENERAL              │
        │   ARRANGEMENT  MODEL            │
        └────────────────┬────────────────┘
                         │ ◄──────────────────────────────┐
        ┌────────────────┴────────────────┐               │
  S20   │   DESIGN EVALUATION             │               │
        └────────────────┬────────────────┘               │
     S30                 │                                 │
          ◇─────────────────────◇   NO                     │
         ◇      PASSED ?          ◇──────────┐       S40    │
          ◇─────────────────────◇            ▼              │
                    │ YES            ┌─────────────────────┐│
        ┌───────────┴──────────┐    │  CHANGE  GENERAL    ││
  S50   │ FIT FINAL LINE PLAN   │    │  ARRANGEMENT  MODEL ││
        └───────────┬──────────┘    └──────────┬──────────┘│
        ┌───────────┴──────────┐               └───────────┘
  S60   │  MANUFACTURE  SHIP    │
        └───────────┬──────────┘
                    │
              ┌─────┴─────┐
              │    END    │
              └───────────┘
```

Fig. 8

Fig. 9

Fig.10

Fig.11

# Fig. 12

**INTERNATIONAL SEARCH REPORT**

| International application No. |
| --- |
| PCT/JP2011/072813 |

A.  CLASSIFICATION OF SUBJECT MATTER
*B63B9/00*(2006.01)i, *G06F17/50*(2006.01)i

According to International Patent Classification (IPC) or to both national classification and IPC

B.  FIELDS SEARCHED

Minimum documentation searched (classification system followed by classification symbols)
B63B9/00, G06F17/50

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| Y | Kazuo KOMATA et al., "Mitsui Zosen no IT eno Torikumi Jirei", Journal of the Japan Institute of Marine Engineering, 2001.10, vol.36, no.10, pages 813 to 821 | 1-16 |
| Y | Kazuhiro AOYAMA et al., "Development of design supporting system for merchant ship based on top-down oriented approach and stepwise detailing information model", Journal of the Society of Naval Architects of Japan, 2002.12, no.192, pages 453 to 464 | 1-16 |

☐  Further documents are listed in the continuation of Box C.       ☐  See patent family annex.

| | | |
| --- | --- | --- |
| *     Special categories of cited documents: | "T" | later document published after the international filing date or priority date and not in conflict with the application but cited to understand the principle or theory underlying the invention |
| "A"   document defining the general state of the art which is not considered to be of particular relevance | | |
| "E"   earlier application or patent but published on or after the international filing date | "X" | document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O"   document referring to an oral disclosure, use, exhibition or other means | | |
| "P"   document published prior to the international filing date but later than the priority date claimed | "&" | document member of the same patent family |

| Date of the actual completion of the international search | Date of mailing of the international search report |
| --- | --- |
| 27 December, 2011 (27.12.11) | 10 January, 2012 (10.01.12) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004009858 A
- JP 2004118266 A
- JP 2006221534 A
- JP 2010225695 A